(19) Europäisches Patentamt
European Patent Office
Office européen des brevets

(11) Publication number: **0 008 215**
**B1**

(12) **EUROPEAN PATENT SPECIFICATION**

(45) Date of publication of patent specification: **09.01.85**

(51) Int. Cl.$^4$: **C 07 F 7/00,** C 07 F 9/00, G 02 B 1/10, H 01 L 31/02, C 03 C 17/25

(21) Application number: **79301583.5**

(22) Date of filing: **06.08.79**

(54) **Polymerized solutions of an oxide; method of preparation thereof; method of preparing alkoxyde coatings on substrates, such as solar cells, and product so obtained.**

(30) Priority: **08.08.78 US 931346**

(43) Date of publication of application:
**20.02.80 Bulletin 80/04**

(45) Publication of the grant of the patent:
**09.01.85 Bulletin 85/02**

(84) Designated Contracting States:
**BE CH DE FR GB IT NL SE**

(56) References cited:
**US-A-2 689 858**
**US-A-3 017 282**
**US-A-3 460 956**
**US-A-3 533 850**
**US-A-3 554 698**

**JOURNAL OF THE ELECTROCHEMICAL SOCIETY, vol. 125, no. 6, June 1978 pages 983-985 H.J. HOVEL: "TiO2 Antireflection Coatings by a Low Temperature Spray Process"**

(73) Proprietor: **WESTINGHOUSE ELECTRIC CORPORATION**
**Westinghouse Building Gateway Center**
**Pittsburgh Pennsylvania 15222 (US)**

(72) Inventor: **Yoldas, Bulent Erturk**
**1605 Jamestown Place**
**Pittsburgh, Pennsylvania (US)**

(74) Representative: **Marchant, James Ian et al**
**Elkington and Fife High Holborn House 52/54**
**High Holborn**
**London WC1V 6SH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 008 215 B1

Courier Press, Leamington Spa, England.

## Description

This invention relates to polymerized solutions for depositing optical oxide coatings.

Due to the shortage of hydrocarbon fuels, the importance of silicon solar cells as an energy source has increased greatly in the last few years. The efficiency of silicon in absorbing solar radiation, however, is only about 60%, the other 40% being reflected back into the atmosphere. The amount of light reflected can be reduced by coating the silicon with a material having an index of refraction between that of silicon and air according to Fresnel's equation:

$$R=\left(\frac{n_1^2-n_0n_2}{n_1^2+n_0n_2}\right)^2$$

where $n_0$ is the index of air, $n_1$ is the index of the coating, and $n_2$ is the index of the silicon.

Thus, for silicon, which has an index of about 4, the coating should have an index of about 2.0. (If the coating is applied on a slightly oxidized surface, the index may have to be adjusted). This maximum reduction in the amount of light reflected is achieved at a coating thickness of one quarter of a wavelength.

Presently, it is known how to deposit coatings having specific indices of refraction. For example $TiO_2$ coatings have an indes of 2.5 to 2.7, $Al_2O_3$ coatings have an index of 1.76, $SiO_2$ coatings of 1.55 etc. In addition to the fact that the indices of refraction of these coatings are not exactly 2 (or whatever index is needed), the chemical vapour deposition, vacuum deposition, and RF sputtering techniques for applying them are very expensive.

United States Patent No. 3,460,956 (Dalle) discloses that an alcoholic solution of an organo-soluble titanate complex is prepared by reacting a tetraalkyl titanate with more than 1.5 moles of water in the presence of up to 2 moles of lactic acid or 0.5—15 moles nitric acid in a lower alkanol in which the reactants and reaction product are soluble. The resulting solution may be used to produce hard transparent surface coatings and pigments of $TiO_2$ after heat curing.

The Journal of the Electrochemical Society, Vol. 125, No. 6, June 1978, pages 983 to 985, discloses the application of tetraalkoxyl titanates to silicon wafers (for use in solar cells) and subsequent curing to form an oxide coating.

When water and alkoxide are brought into contact in an alcohol diluted system, the system turns cloudy but we have now found that such cloudiness can be avoided by the addition of from 0.014 to 0.2 mole of an inorganic mineral acid per mole of alkoxide to the system.

According to the present invention a clear stable solution comprises

(A) alkoxide having the general formula $M(OR)_n$ where M is 0 to 100%, Ti, 0 to 25% Si, 0 to 100% Ta, and up to 15% of another metal ion which forms an alkoxide, R is alkyl from $C_1$ to $C_6$, and n is the valence of M;

(B) from 1.7 to 4 moles of water per mole of said alkoxide; and

(C) sufficient alcohol to give a solids content of from 0.1 to 15% by weight based on equivalent oxide;

characterised in that the solution contains from 0.014 to 0.2 mole of an organic mineral acid per mole of said alkoxide in order to prevent cloudiness.

Additionally, according to the invention is a method of preparing a clear, stable solution which comprises:

(A) adding sufficient alcohol to give a final solids content of from 0.1 to 15% by weight based on equivalent oxide to either or both of:

(1) alkoxide having the general formula $M(OR)_n$ where M is 0 to 100% Ti, 0 to 30% Ti, 0 to 30% Si, 0 to 100% Ta and up to 15% of another metal ion which forms an alkoxide R is alkyl from $C_1$ to $C_6$ and n is the valence of M; and

(2) from 1.7 to 4 moles of water per mole of alkoxide; and

(B) mixing together said alkoxide and said water;

characterised in that from 0.014 to 0.2 mole of an inorganic mineral acid per mole of said alkoxide is added in order to prevent cloudiness.

The invention also includes a method of preparing an oxide coating on a substrate which comprises:

(A) preparing a clear solution as described in the penultimate preceding paragram and when M is a mixture of Ti and Si;

(B) applying said clear solution to said substrate; and

(C) heating said substrate to from 300 to 600°C to transform the alkoxide layer into an oxide coating, said coating having a predetermined index of refraction of from 1.4 to 2.4.

Further, according to the invention is a solar cell including a silicon substrate coated by the method of the last preceding paragraph.

It has now been discovered how to make clear solutions which contain oxide constituents in a

soluble polymerized form and from which uniform and continuous glass-like oxide films can be deposited on substrates at relatively low temperatures. From these solutions quarterwave anti-reflective (AR) coatings of desired thickness and refractive index can be deposited on photovoltaic cells and on other substrates. The solutions are made of a metal alkoxide, an alcohol, and water by a partial hydrolysis and polymerization process. They are applied to the substrate by any liquid application methods such as dipping or spraying, and the solvent and organics are evaporated. After a low temperature baking, the coating converts to a transparent, continuous oxide film tenaciously bonded on the substrate. The optical quality of the films are equivalent or better than the presently used more expensive methods such as vacuum deposition.

It has also now been found that the index of refraction of the coating can be varied continuously from 1.4 to 2.4 by using mixtures of alkoxides and by controlling processing variables, thus permitting fine-tuning of the index for AR coatings on different substrates and for specific wavelength of light. Also, a coating which is anti-reflective over a broad band can be made by making the coating with two layers of different indexes or materials processed differently.

The solution and coatings of this invention are optically clear and have about the same physical properties as coatings deposited by prior techniques, but when optimum approach nearly the maximum reduction in reflectivity that is theoretically possible.

The coating techniques of this invention are well suited for continuous mass production of AR coating at a fraction of the cost of prior techniques. Existing process for coating solar cells cost about 20 cents a watt; this process would cost one-half to one cent per watt at present prices.

In order that the invention can be more clearly understood, convenient embodiments thereof will now be described, by way of example, with reference to the accompanying drawings;

Figure 1 is an isometric view, in section, of a solar cell and

Figures 2 to 9 are graphs depicting experimental results described in the Examples.

Referring to Figure 1, a silicon wafer 1 is composed of an N layer 2, a P layer 3, and a $P^+$ layer 4 from which electricity is drawn by grids 5 and 6 attached thereto respectively. On the surface of wafer 1 which is exposed to light is a coating 7 about 1/4 wavelength thick according to this invention. The coating reduces the reflection of light back to its source and thereby enhances the efficiency of the solar cell. The captured light causes electrons to move from the N layer to the $P^+$ layer thereby generating an electric current.

The coating shown in Figure 1 is deposited from a solution derived from metal alkoxides. Alkoxides useful in this invention have the general formula $M(OR)_n$. In the formula, "M" represents a metal ion. This ion is preferably titanium as it is commercially the most important but it can also be tantalum. Lesser amounts of other alkoxides can be included as dopants to alter the index of refraction of the coating. For example, up to 25% (by weight) of the M ion content can be silicon or up to 15% (by weight) of the M ion content can be another M ion that forms a compatible alkoxide, such as boron, aluminum, zirconium. The small "n" in the formula is the valence of the M ion and can vary from 3 to 5. The R group is alkyl from $C_1$ to $C_6$. Each R group may be independently selected if desired though they are usually the same. The R group is preferably ethyl, isopropyl, or butyl because these alkoxides are commercially available and inexpensive. Also, the alcohols which are formed from these alkyl groups mix with water in the range of the invention.

The alcohols used in preparing the coating solutions can be any liquid alcohol, although ethanol is preferred as it is inexpensive. Higher alcohols produce thicker films. The alcohol need not be the same alcohol that is produced by the hydrolysis of the alkoxide, and in some instances it is desirable that they be different in order to obtain different viscosities. The amount of alcohol used should be sufficient to produce a solution having a solids content of from 0.1 to 15% by weight based on equivalent $TiO_2$. A greater solids content for the same degree of hydrolysis will cause the solution to gel and a lesser solids content results in undesirably thin coatings. A preferred solids content is about 2 to about 8% by weight based on equivalent $TiO_2$. Stated another way, the preferred maximum is about 1 mole alkoxide per liter of final solution.

Metal-alkoxides, in general, hydrolyze quite vigorously when brought into contact with water forming oxides and hydroxides as represented by reactions.

$$M(OR)_n + nH_2O \rightarrow M(OH)_n + nR(OH) \quad (1)$$

$$M(OR)_n + n/2\ H_2O \rightarrow MOn/2 + nROH \quad (2)$$

Whether the oxide or the hydroxide forms during the hydrolysis depends on the nature of the alkoxide. In either case, however, the resultant material is particulate, precipitates out, and therefore is not useful for coating. The alkoxides of titanium and tantalum, particularly, form precipitates even under insufficient water hydrolysis, and the formation of precipitates cannot be prevented in under normal conditions. However, a method of preparing soluble intermediate species from these alkoxides has been found which are capable of polymerizing into an oxide network. Precipitate formation and selfcondensation which would normally occur during the hydrolysis of these alkoxides are prevented from occurring by a careful control of molecular interaction during the hydrolysis where certain amounts of

(OR) groups are left in the molecular structure. This is done firstly by controlling the amount of water and dilution of the system, and secondly by the presence of a critical amount of certain acids.

Because the water and/or alkoxide is diluted by the alcohol, the interaction of alkoxide and water molecules are reduced to a critical minimum where the complete hydrolysis of an alkoxide molecule cannot take place, occurrence of which would precipitate $TiO_2$. The first reaction produces a partially hydrolyzed alkoxide which does not precipitate:

$$Ti(OR)_4+H_2O \rightarrow Ti(OR)_3OH$$

The partially hydrolyzed alkoxide molecules include $Ti(OR)_2(OH)_2$, $Ti(OR)(OH)_3$ and can then form a polymer with other alkoxide molecules.

$$(RO)_3Ti{-}OH+RO{-}Ti(OR)_3 \rightarrow (RO)_3Ti{-}O{-}Ti(OR)_3+ROH$$

which can again react with other partially hydrolyzed titanium species. Because of the alkyl groups in the polymer it remains soluble in the alcohol. To keep the polymer soluble, it is necessary that not all the alkoxide bonds be hydrolyzed. Thus, the amount of water added is absolutely critical. If the amount is less than 1.7 moles of water per mole of alkoxide the coatings may be permanently cloudy and if more than 4 moles of water per mole of alkoxide is used, the solution will gel fairly quickly. Preferably, the amount of water should be 1.8 to 2.2 moles per mole of alkoxide.

In preparing the solution it is important to avoid contacting alkoxide with water without diluting one or both of them with alcohol first for otherwise a precipitate will form at the point of contact. Although either or both the water and alkoxide can be diluted with alcohol first, it is preferable to dilute the water, then to mix the water-alcohol mixture with the alkoxide. There should be a minimum of 600 cc of alcohol used per mole of alkoxide; the preferable diluting range however is 2 to 8 liters of alcohol per mole of alkoxide.

When water and the alkoxide are brought into contact in an alcohol diluted system, the system turns cloudy. We have found that this cloudiness, which indicates condensation of separate particles, can be totally avoided by introducing at least 0.014 moles of either $HNO_3$ or HCl acids as heretofore described. If the introduction of acid is made into the water-alcohol solution before mixing with the alkoxide no cloudiness ever occurs, and this is therefore the preferred method of introducing the acid. Acid can be added anytime after the mixing occurs and it will cause the cloudy slurry to turn into a clear solution. However, if more than 0.2 moles of acid used per mole of alkoxide, the solubility of the solution is reduced and it will turn cloudy after several days. So far, no organic acids have been found which work, and of the inorganic mineral acids, hydrochloric acid and nitric acid have been found to work.

The solution, once prepared, should be aged for a few hours to permit the polymerization to proceed and stabilize. The solution should be clear at this stage. A clear solution indicates that a single continuous phase has been made rather than a particulate suspension or a precipitate. (A gel cannot be dissolved by adding solvent). To make a coating from the solution, it is first applied to a substrate. Application may be by spraying, painting, spinning, or other suitable method but dipping is the preferred method as it is most easily adapted to mass production.

For an anti-reflective coating on a solar cell, the substrate is usually silicon either in the form of wafers or as a continuous strip. Since silicon solar cells are most sensitive at a wavelength of about 6,000Å, a one-fourth wavelength thick coating should be about 600 to about 750 Å. Another application of the coating is as an infrared reflective coating for incandescent light bulbs. By coating the inside of the bulb the infrared light is reflected back inside the bulb which results in less electricity being used for a given light output. Other useful substrates include various glasses such as gallium arsenide or calgoginide glasses where the coating can reduce reflection.

After the substrate has been coated, it is heated to at least 300°C to drive off solvent and organics and form an inorganic metal oxide polymer. The film resulting after the heat treatment is continuous, has a uniform thickness within several Angstroms, and is tenaciously bonded onto the substrate. A temperature of 350°C is needed to drive out remaining organic groups, but it may be desirable for some applications to leave some organics in the coating to lower the index of refraction as is illustrated in the examples. If the material is heated above about 600°C, it tends to become crystalline rather than amorphous. If the $TiO_2$ film thus obtained is heat treated in air it will have an index of refraction around 2.2. However, if the treatment is done in vacuum the index of refraction will be around 2.4. Of course, an index of refraction ranging from 2.4 to all the way down to 1.4 can be obtained by doping the solution with another suitable material. Silicon alkoxides are suitable for this purpose. Figure 3 gives the precise composition for any desired index between 2.4 and 1.4. The resulting clear coating has about the same physical properties as coatings formed by prior vacuum techniques, but its optical properties are superior because the best coatings reduce reflectivity to very nearly the maximum amount which is theoretically possible.

When a single coating is applied to a substrate, the reflectivity reduction occurs at a minimum wavelength. The minimum wavelength can be broadened to cover a wide range of wavelengths by

coating the substrate with two layers of film having different indices. For silicon, the lower layer should have an index of about 2.4 and the top layer an index of about 1.4. The lower layer index of 2.4 can be obtained by coating with 100% $TiO_2$ in vacuum. The top layer index of 1.4 can be obtained by coating with a 90%—10% mixture of $SiO_2$ and $TiO_2$ in air. Both coatings should each be a quarter wavelength thick. Each layer is fired separately.

The invention will now be illustrated with reference to the following Examples:

Example 1

18 g of $H_2O$ and 0.7 g $HNO_3$ were mixed well into 1000 g of ethyl alcohol. To this 114 g (1/2 mole) titanium tetra-ethoxide $Ti(OC_2H_5)_4$ was gradually added. A clear solution resulted. This solution was allowed to stand several hours. A dendritic-web silicon ribbon having 1/2 inch width was immersed in it. This sample was then withdrawn from the solution at a rate of 40 cm/min and baked in air at 400°C for a few minutes. A uniform antireflective film of titanium oxide having a thickness of 680Å and refractive index of 2.12 was formed on the silicon ribbon.

Example 2

18 g of $H_2O$ was mixed well into 1000 g of ethyl alcohol. To this 170 g (1/2 mole) titanium butoxide, $Ti(OC_4H_9)_4$ was added under stirring. Within a few minutes the entire solution turned cloudy. To this 0.9 g of 70% concentrated nitric acid was added (0.02 mole $HNO_3$ per mole of alkoxide) with stirring. The milky slurry became clear within minutes. This solution was then spin applied on Czochalski-type round silicon wafers 1-1/4" in diameter at 900 rpm. When these wafers were fired in air they had a coating with a refractive index slightly over 2.1 and a thickness around 640Å. Similarly coated wafers heat treated in vacuum had a refractive index around 2.4.

Example 3

0.36 g (.02 moles) $H_2O$ was mixed into 27 g ethyl alcohol. Into this, 4.06 g tantalum alkoxide, $Ta(OC_2H_5)_5$, was introduced under mixing. A clear liquid resulted. After 10 minutes of standing at room temperature, this solution acquired a milky appearance. 1 drop of $HNO_3$ acid was introduced into the solution and mixed. The cloudy appearance disappeared. It contained 7% equivalent $Ta_2O_5$ by weight.

After 3 days of aging, the solution described above was applied on a silicon solar cell with a spin application at 2500 rpm. The coated cell was then baked at 400°C for 5 minutes. The following test results show the performance of the cell before and after the coating.

| | $I_{sc}$(ma) | $V_{oc}$(V) | Efficiency (%) |
|---|---|---|---|
| Before Coating: | 21.20 | 0.539 | 8.95 |
| After Coating: | 28.6 | 0.552 | 12.7 |

$I_{sc}$=short circuit current
$V_{oc}$=voltage (open circuit)

$$\text{Increase in efficiency by coating}=\frac{12.7-8.9}{8.9}.42=42\%.$$

Example 4

15 g $H_2O$, 15 g silicon tetraethoxide ($Si(OC_2H_5)_4$), and 0.6 g nitric acid were mixed into 8530 g ethyl alcohol. Into this 116 g of titanium isopropoxide ($Ti(OC_3H_7)_4$) was added gradually. A clear solution having 3.7 weight percent equivalent titania concentration resulted. Similarly, by using larger quantities of ethyl alcohol, solution having 0.5, 1.0, and 2.0 weight percent equivalent titania concentrations were also prepared. One-half inch wide 3 ft. long stainless steel ribbons were immersed in these solutions after 1 day aging. These samples were then withdrawn from the solutions at various speeds up to 64 ft/min. They were baked in air at 400°C for 5 minutes. The coating thicknesses were then measured. Figure 2 shows the effect of solution concentration and withdrawal rates on the thickness of films.

Example 5

The following two solutions were prepared:

Solution A

20.8 g silicon tetraethoxide, $Si(OC_2H_5)_4$ was mixed with 148 g ethyl alcohol. Precisely 1.8 g $H_2O$ was also added along with 1 drop of $HNO_3$ and the mixture was refluxed at 60°C for several hours then set aside to cool. This gave a partially hydrolyzed silanol solution containing 3.5 wt.% equivalent $SiO_2$.

Solution B

22.8 g $Ti(OC_2H_5)_4$ was added to 102 g ethyl alcohol. 3.5 g $H_2O$ and 4 drop of HCl acid were added to 100 g ethyl alcohol. These two preparations were mixed and aged several hours. The resultant liquid had a 3.5 wt.% equivalent $TiO^2$.

The two solutions were then mixed in various proportions and were permitted to age for several hours. The mixtures were deposited on silicon wafers by spinning at 1000 rpm and were heated in air and in vacuum at 500°C to form coatings about 600Å thick. Figure 3 shows that the index of refraction depends on the proportion of $TiO_2$ to $SiO_2$ and on whether the coating was fired in air or in vacuum. A vacuum produces a denser coating having a higher index of refraction.

Example 6

Example 5 was repeated except that Solution B contained 3.5 equivalent of $TiO_2$. The solution was placed on a silicon wafer and centrifuged at speeds ranging from 500 to 5,000 rpm before being heated at 500°C. Figure 4 shows the effect of centrifuge speed on film thickness.

Example 7

Example 6 was repeated at a centrifuge speed of 2000 rpm, except that the solutions were then baked at 250°C to 500°C. Figure 5 shows the effect that bake temperature has on film thickness and index of refraction. Figure 6 shows the reflectivity of the surface films baked at various temperatures. It also shows how the minimum reflectivity can be shifted at various wavelengths with bake temperatures.

Example 8

Example 6 was repeated except that the solution was 3.0% equivalent $TiO_2$ (2 moles $H_2O$), the alcohol was a mixture of ethanol and tertiary butanol, and the wafer was spun at 2,000 rpm. Figure 7 shows the effect on film thickness of various proportions of ethanol and t-butanol. Figure 7 shows that the thickness of the film can be controlled by the type of alcohol used.

Example 9

Example 6 was repeated using 2.5 moles of water per mole of $Ti(OC_2H_5)$ and controlling equivalent $TiO_2$ concentration by dilution with ethanol. Solutions were then coated on silicon wafers at 2000 rpm and baked at 500°C. Figure 8 shows the relationship between solution concentration and film thickness. This gives another method of controlling film thickness.

Example 10

$P^+$ back surface field silicon solar cells having active areas slightly over 1 $cm^2$ were employed for antireflective testing. The silica and titania solutions were prepared as described in Example 5. These solutions were mixed to prepare a third solution to coat an oxide film with an index of 2 as indicated by Figure 3 which requires 88% of $TiO_2$ and 12% of $SiO_2$. The fine tuning of the coating thickness is done by varying the rpm in spin application and the drawing speed in the dipping application. The solutions used required a spin speed of 800—1,000 rpm. The dipping was done by immersing the entire sample into the coating liquid and pulling it out at a continuous speed. It was found that extremely uniform anti-reflective coatings are deposited at a pulling rate 1—2 ft/min. It also appears to be feasible to increase this speed an order of magnitude or more by using diluted solutions. The following table gives the results.

| Solar cell | $I^*_{sc}$ (mA) Uncoated | Coated | Efficiency (%)*** Uncoated | Coated | Improvement |
|---|---|---|---|---|---|
| A | 21.10 | 29.40 | 8.56 | 12.24 | 43% |
| B | 21.60 | 31.00 | 9.37 | 13.34 | 42% |
| C | 21.40 | 30.50 | 9.03 | 12.91 | 43% |
| D | 20.80 | 28.90 | 8.65 | 12.82 | 48% |
| E | 22.00 | 30.50 | 9.43 | 14.04 | 49% |

*=Short circuit current.

***=Calculation of efficiency takes into account changes in open circuit voltage and fill factor which are relatively insensitive to AR coatings and therefore not given here separately.

The E cell was a doubly-coated cell with films of two different indices. The rest of the cells are coated with single anti-reflective film with an index of 2. As shown, these cells showed as much as 48% increase in the efficiency.

From a purely theoretical point of view, if the reflection were to be eliminated entirely, there would be about 60% more energy available to the device over the uncoated state (38/62=60%). However, this sixty percent is unattainable as an increase in device electrical output for several reasons. First, the zero reflectivity occurs only at one wavelength, not throughout the entire spectrum. Secondly, the response of the silicon device varies with the wavelength; therefore, it will not respond to all of the energy gain. For these reasons, the actual limit on potential efficiency increase with an anti-reflective coating is estimated to be about 50%. The 48 to 49% increase in efficiencies recently attained in this work appears to approach this limit.

Example 11

Single coatings produce minimum reflectivity at a wavelength given by $\lambda=4n_ct_c$ where $n_c$ and $t_c$ are the index and thickness of the coating respectively. All other wavelengths, however, are reflected with increasing intensity as they deviate from this value. Since in photovoltaic silicon cells the energy conversion takes place in the range of wavelengths covering approximately the solar spectrum, it is highly desirable to produce coatings whose antireflective characteristics also cover the entire range of solar spectrum.

It has been demonstrated that quarterwave double AR coatings can also be deposited by the technique of this invention.

A silicon wafer was initially coated with a quarter wave thick $TiO_2$ film fired in vacuum and having an index of 2.4. The solution used was similar to that of Example 1. Then a second quarter wave film having a composition of 90% $SiO_2$—10% $TiO_2$ was deposited from a solution prepared similarly to Example 5. As predicted by Figure 3 this second coating had a refractive index of 1.4.

The combined reflectivity of this double film is shown in Figure 9. As was predicted, a wide spectrum of antireflectivity was obtained. The total reflectivity as integrated over the 4500Å to 900Å range was less than 3% (uncoated silicon surfaces reflect about 40% in this range). A solar cell coated with double film showed 49% improvement in efficiency (see "solar cell E" in Example 10).

**Claims**

1. A clear stable solution which comprises:

(A) alkoxide having the general formula $M(OR)_n$ where M is 0 to 100% Ti, 0 to 25% Si, 0 to 100% Ta, and up to 15% of another metal ion which forms an alkoxide, R is alkyl from $C_1$ to $C_6$, and n is the valence of M;

(B) from 1.7 to 4 moles of water per mole of said alkoxide;

(C) sufficient alcohol to give a solids content of from 0.1 to 15% by weight based on equivalent oxide;

characterised in that the solution contains from 0.014 to 0.2 mole of an inorganic acid per mole of said alkoxide in order to prevent cloudiness.

2. A solution according to claim 1, wherein the solids content is from 2 to 8% by weight based on equivalent oxide.

3. A solution according to claim 2, wherein the acid is at least one of nitric acid and hydrochloric acid.

4. A solution according to any of claims 1 to 3, wherein the alcohol is ethyl alcohol.

5. A solution according to any of claims 1 to 3, wherein R is at least one of ethyl, isopropyl and butyl.

6. A solution according to any of claims 1 to 5, wherein M is all Ti.

7. A solution according to any of claims 1 to 5, wherein M is a mixture of Ti and Si.

8. A method of preparing a clear stable solution of a metal alkoxide which comprises:

(A) adding sufficient alcohol to give a final solids content of from 0.1 to 15% by weight based on equivalent oxide to either or both of:

(1) alkoxide having the general formula $M(OR)_n$ where M is 0 to 100% Ti, 0 to 30% Si, 0 to 100 Ta, and up to 15% of another metal ion which forms an alkoxide R is alkyl from $C_1$ to $C_6$ and n is the valence of M; and

(2) from 1.7 to 4 moles of water per mole of alkoxide; and

(B) mixing together said alkoxide and said water;

characterised in that from 0.014 to 0.2 mole of an inorganic mineral acid is added per mole of said alkoxide in order to prevent cloudiness.

9. A method according to claim 8, wherein the alcohol is added entirely to the water.

10. A method of preparing an oxide coating on a substrate which comprises:

(A) preparing a clear solution according to claim 8;

(B) applying said clear solution to said substrate; and

(C) heating said substrate to from 300 to 600°C to transform the alkoxide layer into an oxide coating, said coating having a predetermined index of refraction of from 1.4 to 2.4.

11. A method according to claim 10, wherein the substrate is heated in a vacuum.

12. A method according to claim 10 or 11, wherein the substrate is silicon.

13. A method according to claim 10, 11 or 12, wherein the application is by dipping.

14. A method according to any of claims 10 to 13, wherein the coating is from 600 to 750A thick.

15. A method according to any of claims 10 to 13, wherein the method is applied twice to the same substrate so that a two-layered coating is produced.

16. A method according to claim 15, wherein the lower layer is $TiO_2$ fired in vacuum and the top layer is 90% $TiO_2$ and 10% $SiO_2$ fired in air and each layer is a quarter wavelength in thickness.

17. Clear solutions when made by a method as claimed in claim 8 or 9.

18. Substrate coated with an oxide coating when made by a method as claimed in any of claims 10 to 16.

19. Substrate according to claim 20, wherein said substrate is the inside of an incandescent light bulb.

20. Solar cells including a coated substrate as claimed in claim 18 when that substrate is silicon.

**Revendications**

1. D'une solution limpide stable comprenant:

(A) de l'alcoolate dont la formule générale est $M(OR)_n$ où M représente 0 à 100% de Ti, 0 à 25% de Si, 0 à 100% de Ta et jusqu'à 15% d'un autre ion métal formant un alcoolate compatible, R correspond à un alkyle de la gamme $C_1$—$C_6$, et n est l'indice de valence de M;

(B) entre 1,7 et 4 moles d'eau par mole dudit alcoolate;

(C) une proportion suffisante d'alcool pour obtenir une teneur un extrait sec de 0,1 à 15% en poids sur la base d'oxude équivalent;

et se caractérisant par le fait que ladite solution contient entre 0,014 à 0,2 mole d'un acide inorganique par mole dudit alcoolate pour empêcher que celle-ci ne devienne trouble.

2. Une solution conforme à la revendication 1, où la teneur un extrait sec est comprise entre 2 et 8% en poids sur la base d'oxyde équivalent.

3. Une solution conforme à la revendication 2, où l'acide est au moins un acide nitrique ou un acide chlorhydrique.

4. Une solution conforme à l'une quelconque des revendications 1 à 3, où l'alcool est un alcool éthylique.

5. Une solution conforme à l'une quelconque des revendications 1 à 3, où R appartient au moins au groupe éthyle, isopropyle ou butyle.

6. Une solution conforme à l'une quelconque des revendications 1 à 5, où M correspond uniquement à du Ti.

7. Une solution conforme à l'une quelconque des revendications 1 à 5, où M représente un mélange de Ti et de Si.

8. Une méthode de préparation d'une solution limpide stable d'alcoolate métallique se composant:

(A) d'une proportion suffisante d'alcool pour obtenir une teneur finale en extrait sec comprise entre 0,1 et 15% en poids sur la base d'oxyde équivalent, cette proportion d'alcool étant ajoutée à l'un ou l'autre ou aux deux des constituants suivants:

(1) l'alcoolate dont la formule générale est $M(OR)_n$, où M représente 0 à 100% de Ti, 0 à 30% de Si, 0 à 100% de Ta et jusqu'à 15% d'un autre ion métal formant un alcoolate compatible, où R correspond à une alkyle de la gamme $C_1$—$C_6$ et n est l'indice de valence de M; et

(2) entre 1,7 à 4 moles d'eau par mole d'alcoolate; et

(B) du mélange desdits alcoolate et eau;

et se caractérisant par le fait qu'entre 0,014 à 0,2 mole d'acide minéral inorganique par mole d'alcoolate est ajouté à ladite solution pour l'empêcher de devenir trouble.

9. Une méthode conforme à la revendication 8, où l'alcool est ajouté uniquement à l'eau.

10. Une méthode portant sur la préparation d'un revêtement oxydé destiné à être appliqué sur un support et caractérisée par les points suivants:

(A) la préparation d'une solution limpide conformément à la revendication 8;

(B) l'application de ladite solution pimpide sur ledit support; et

(C) la cuisson dudit support à une température de 300 à 600°C pour transformer la couche d'alcoolate en un revêtement oxydé, ledit revêtement ayant un indice de réfraction préétabli de l'ordre de 1,4 à 2,4.

11. Une méthode conforme à la revendication 10, où le support est chauffé à vide.

12. Une méthode conforme à la revendication 10 ou 11, où le support est du silicium.

13. Une méthode conforme à la revendication 10, 11 ou 12, où l'application est effectuée par immersion.

14. Une méthode conforme à l'une quelconque des revendications 10 à 13, où le revêtement a une épaisseur comprise entre 600 et 750A.

15. Une méthode conforme à l'une quelconque des revendications 10 à 13, où l'application est répétée deux fois sur le même support de manière à obtenir un revêtement à deux couches.

16. Une méthode conforme à la revendication 15, où la couche inférieure à base de $TiO_2$ est cuite à vide et la couche supérieure composée à 90% de $TiO_2$ et à 10% de $SiO_2$ est cuite à l'air, chaque couche ayant une épaisseur d'un quart d'onde.

17. Des solutions limpides préparées selon la méthode revendiquée au point 8 ou 9.

18. Un support recouvert d'un revêtement oxydé obtenu à l'aide de la méthode revendiquée à l'un quelconque des points 10 à 16.

19. Un support conforme à la revendication 18, où ledit support représente l'intérieur d'une ampoule d'éclairage à incandescence.

20. Des cellules solaires comprenant un support enduit conformément à la revendication 18, ce support étant du silicium.

**Patentansprüche**

1. Eine klare stabile Lösung, die besteht aus:

(A) einem Alkoxid der allgemeinen Formel $M(OR)_n$, wobei der Bestandteil an M 0 bis 100% Ti, 0 bis 25% Si, 0 bis 100% Ta and bis zu 15% eines anderen Metallions ist, das ein Alkoxid bildet; R ist ein Alkyl von $C_1$ bis $C_6$ und n ist die Valenzzahl von M;

(B) 1,7 bis 4 Molen Wasser pro Mol des besagten Alkoxids;

(C) genügend Alkohol, um einen schwerlöslichen Bestandteil von 0,1 bis 15 Gew. Proz. bezogen auf äquivalentes Oxid zu bilden, und dadurch gekennzeichnet daß die Lösung 0,014 bis 0,2 Mol einer anorganischen Säure pro Mol besagten Alkoxids enthält, um Wolkenbildung zu vermeiden.

2. Eine Lösung nach Anspruch 1, dadurch gekennzeichnet, daß der schwerlösliche Bestandteil 2 bis 8 Gew. Proz. bezogen auf äquivalentes Oxid darstellt.

3. Eine Lösung nach Anspruch 2, dadurch gekennzeichnet, daß als Säure mindestens eine von beiden: Salpetersäure und Salzsäure eingesetzt wird.

4. Eine Lösung nach einem der Ansprüche 1 bis 3, dadurch gekennzeichnet, daß der Alkohol Äthanol ist.

5. Eine Lösung nach einem der Ansprüche 1 bis 3, dadurch gekennzeichnet, daß R mindestens eine der Gruppen Äthyl, Isopropyl und Butyl ist.

6. Eine Lösung nach einem der Ansprüche 1 bis 5, dadurch gekennzeichnet, daß M ausschließlich Ti ist.

7. Eine Lösung nach einem der Ansprüche 1 bis 5, dadurch gekennzeichnet, daß M eine Mischung aus Ti und Si ist.

8. Eine Methode zur Darstellung einer klaren stabilen Lösung eines Metalloxids, die besteht aus;

(A) der Zugabe von genügend Alkohol, um einen resultierenden schwerlöslichen Bestandteil von 0,1 bis 15 Gew. Proz. zu erhalten, bezogen auf eines oder beide der äquivalenten Oxide, gebildet aus;

(1) einem Alkoxid der allgemeinen Formel $M(OR)_n$, dadurch gekennzeichnet, daß M 0 bis 100% Ti, 0 bis 30% Si, 0 bis 100% Ta und bis zu 15% eines anderen Metallions ist, das ein Alkoxid bildet. R ist eine Alkylgruppe von $C_1$ bis $C_6$ und n ist die Valenzzahl von M; und

(2) 1,7 bis 4 Molen Wasser pro Mol Alkoxid; und

(B) dem Zusammenmischen von besagtem Alkoxid und besagtem Wasser, dadurch gekennzeichnet, daß 0,014 bis 0,2 Mole anorganischer Mineralsäure pro Mol besagten Alkoxids hinzugefügt werden, um Wolkenbildung zu vermeiden.

9. Eine Methode nach Anspruch 8, dadurch gekennzeichnet, daß der Alkohol vollständig zum Wasser hinzugefügt wird.

10. Eine Methode zur Vorbereitung einer Oxidbeschichtung auf ein Substrat, die beinhaltet;

(A) die Darstellung einer klaren Lösung nach Anspruch 8;

(B) die Anwendung besagter klarer Lösung auf besagtes Substrat, und

(C) das Erhitzen besagten Substrats auf Temperaturen von 300° bis 600°C, um die Alkoxidlage in eine Oxidbeschichtung umzuwandeln, wobei besagte Beschichtung einen vor bestimmten Refraktionswert von 1,4 bis 2,4 hat.

11. Eine Methode nach Anspruch 10, dadurch gekennzeichnet, daß das Substrat im Vakuum erhitzt wird.

12. Eine Methode nach Ansprüchen 10 oder 11, dadurch gekennzeichnet, daß das Substrat ein Silikon ist.

13. Eine Methode nach Ansprüchen 10, 11 oder 12, dadurch gekennzeichnet, daß die Anwendung durch Eintauchen erfolgt.

14. Eine Methode nach einem der Ansprüche 10 bis 13, dadurch gekennzeichnet, daß die Beschichtung 600 bis 750Å dick ist.

15. Eine Methode nach einem der Ansprüche 10 bis 13, dadurch gekennzeichnet, daß die Methode zweimal auf dasselbe Substrat angewendet wird, so daß eine zweilagige Beschichtung hergestellt wird.

16. Eine Methode nach Anspruch 15, dadurch gekennzeichnet, daß die untere Lage $TiO_2$ ist, die im vakuum erhitzt wird, und daß die obere Lage zu 90% aus $TiO_2$ und 10% aus $SiO_2$ besteht, die unter Luft erhitzt wird, und daß jede Lage eine Dicke von einer Viertelwellenlänge hat.

17. Klare Lösungen, hergestellt nach einer Methode nach Ansprüchen 8 oder 9.

18. Ein Substrat, das mit einer Oxidbeschichtung versehen wird, die nach einer Methode nach einem der Ansprüche 10 bis 16 hergestellt wird.

19. Ein Substrat nach Anspruch 20, dadurch gekennzeichnet, daß besagtes Substrat sich innerhalb einer weißglühenden Glühbirne befindet.

20. Solarzellen, die ein beschichtetes Substrat nach Anspruch 18 beinhalten, dadurch gekennzeichnet, daß jenes Substrat ein Silikon ist.

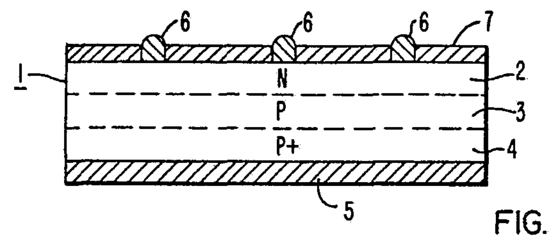
6
6
6
7
1
N
P
P+
2
3
4
5

FIG. 1

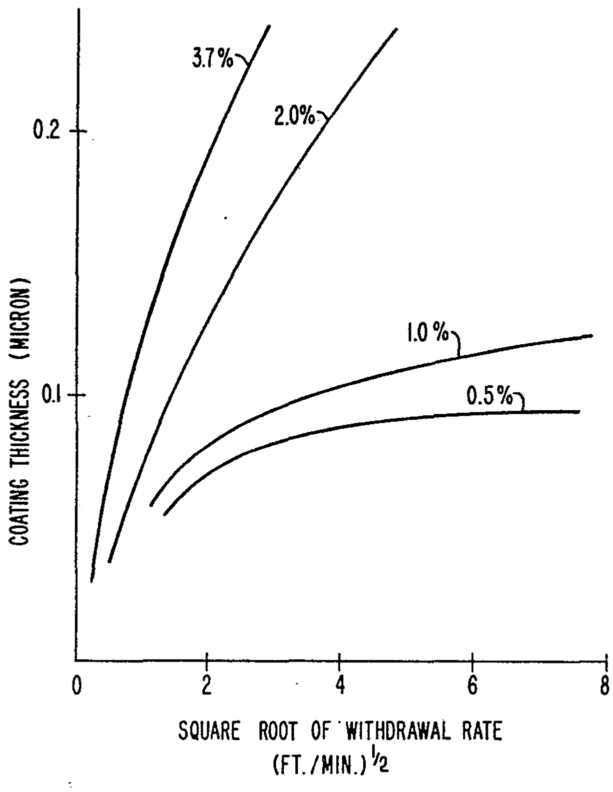
3.7%
2.0%
1.0%
0.5%
0.2
0.1
COATING THICKNESS (MICRON)
0
2
4
6
8
SQUARE ROOT OF WITHDRAWAL RATE
(FT./MIN.)½

FIG. 2

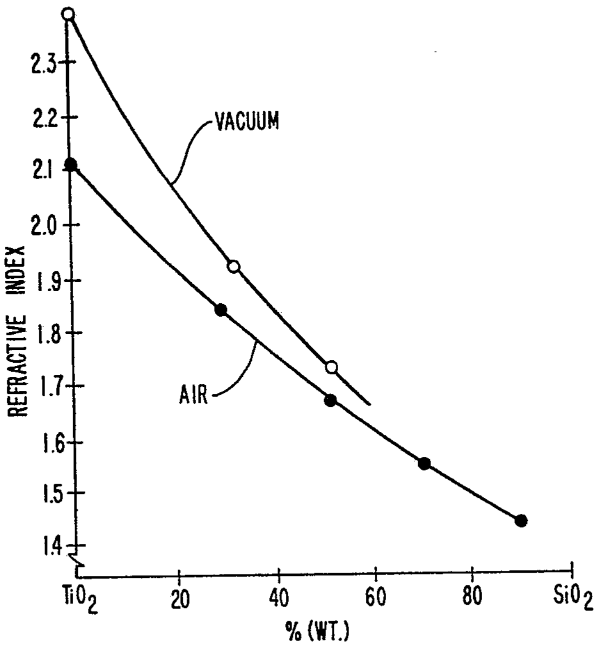
REFRACTIVE INDEX
2.3
2.2
2.1
2.0
1.9
1.8
1.7
1.6
1.5
1.4
VACUUM
AIR
$TiO_2$
20
40
60
80
$SiO_2$
% (WT.)

FIG. 3

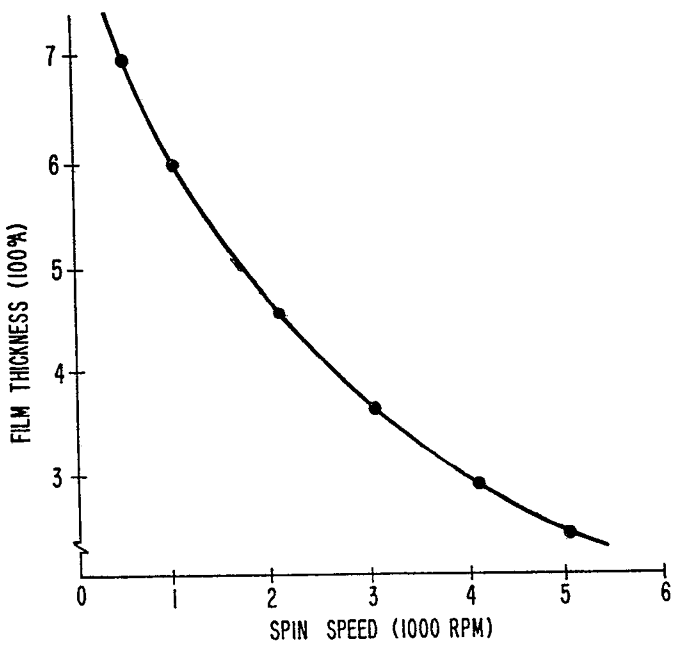
FILM THICKNESS (100Å)
7
6
5
4
3
0
1
2
3
4
5
6
SPIN SPEED (1000 RPM)

FIG. 4

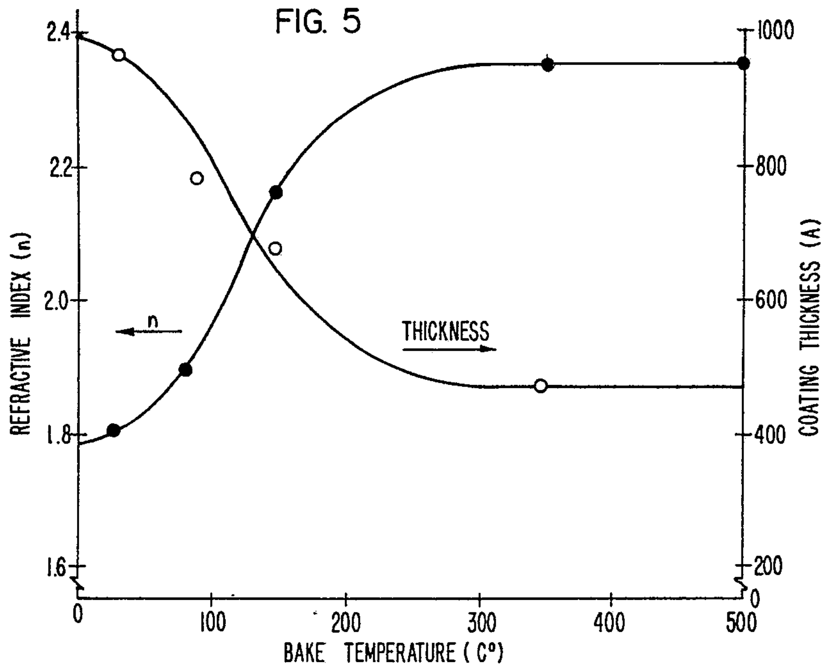
FIG. 5
2.4
2.2
2.0
1.8
1.6
REFRACTIVE INDEX (n)
n
THICKNESS
1000
800
600
400
200
0
COATING THICKNESS (A)
0
100
200
300
400
500
BAKE TEMPERATURE (C°)

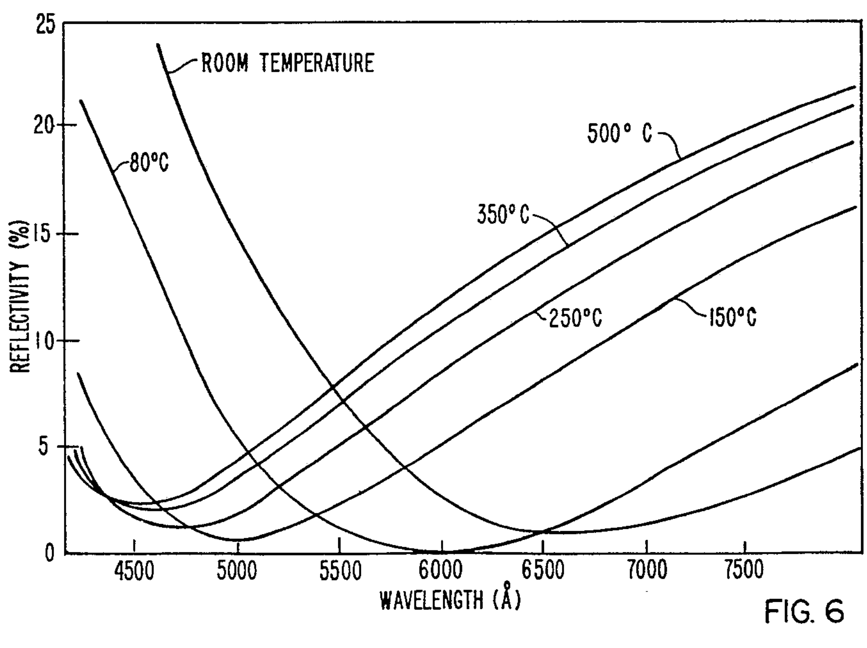
25
20
15
10
5
0
REFLECTIVITY (%)
ROOM TEMPERATURE
80°C
500° C
350° C
250°C
150°C
4500
5000
5500
6000
6500
7000
7500
WAVELENGTH (Å)

FIG. 6

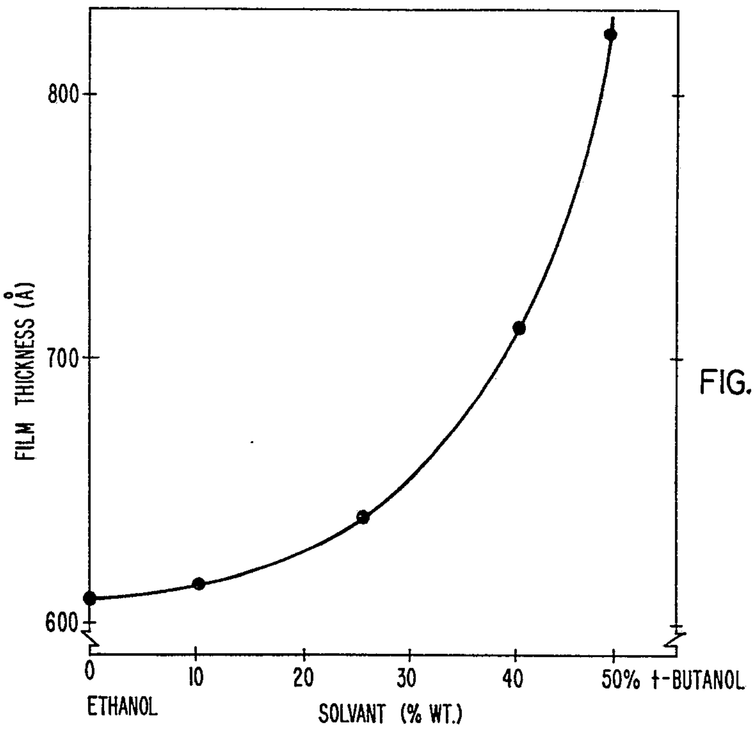
FILM THICKNESS (Å)
800
700
600
0
10
20
30
40
50% t-BUTANOL
ETHANOL
SOLVANT (% WT.)

FIG. 7

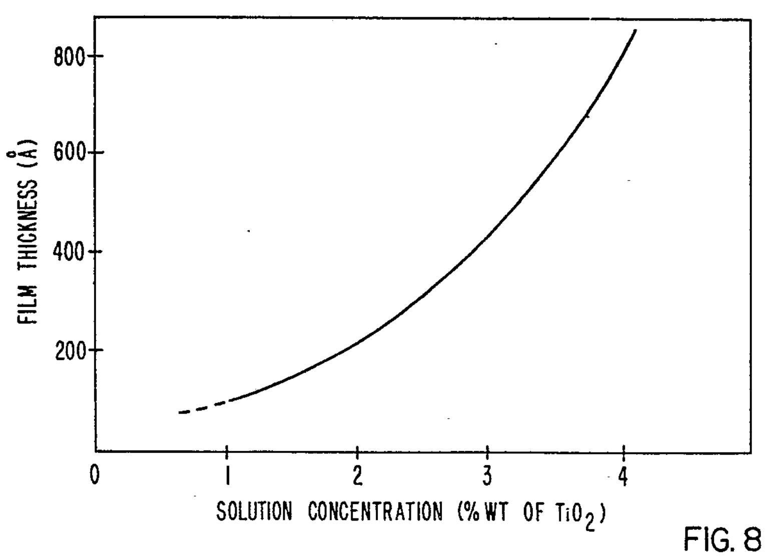
FILM THICKNESS (Å)
800
600
400
200
0
1
2
3
4
SOLUTION CONCENTRATION (% WT OF $TiO_2$)

FIG. 8

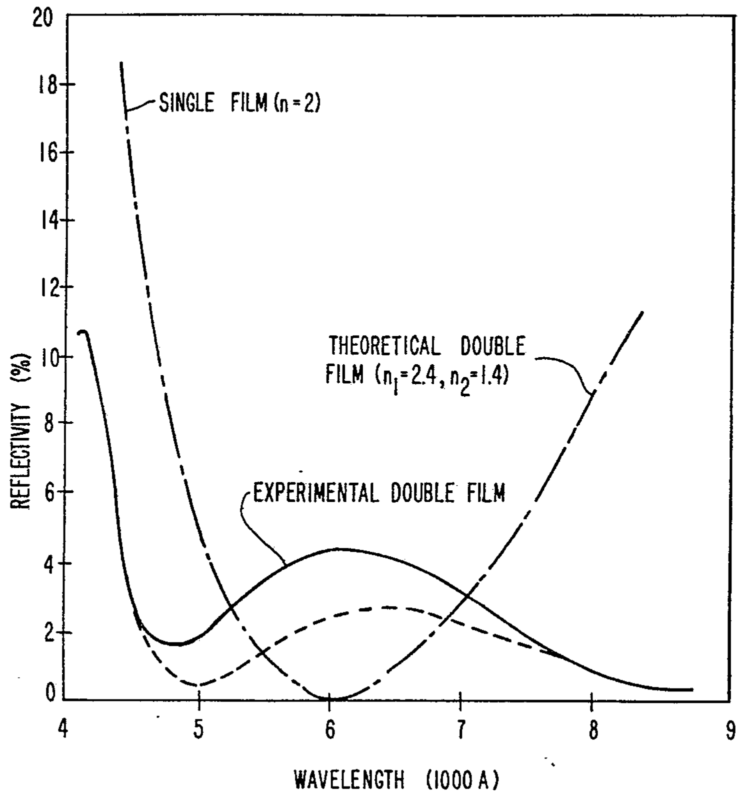

20
18
16
14
12
10
8
6
4
2
0
REFLECTIVITY (%)
SINGLE FILM (n = 2)
THEORETICAL DOUBLE
FILM (n1=2.4, n2=1.4)
EXPERIMENTAL DOUBLE FILM
4
5
6
7
8
9
WAVELENGTH (1000 A)


FIG. 9